# EUROPÄISCHE PATENTSCHRIFT

(11) **EP 1 336 854 B1**
(45) Veröffentlichungstag und Bekanntmachung des Hinweises auf die Patenterteilung: **28.04.2010**
(21) Anmeldenummer: 03003016.7
(22) Anmeldetag: 12.02.2003
(51) Int. Cl.: G01R 19/155, B25B 27/00, B25G 1/12

(54) **Handwerkzeuge mit berührungslosem Spannungsprüfer als Warneinrichtung**
Hand tool with contactless voltage tester as warning device
Outil à main avec détecteur de tension sans contact comme dispositif d'alarme

(30) Priorität: 18.02.2002 IT PT20020004
(43) Veröffentlichungstag der Anmeldung: 20.08.2003
(73) Patentinhaber: Lorenzi, Giampiero, 51011 Buggiano (PT) (IT)
(72) Erfinder: Lorenzi, Giampiero, 51011 Buggiano (PT) (IT)
(74) Vertreter: Oberosler, Ludwig

(56) Entgegenhaltungen:
- DE-A- 3 439 504
- DE-A- 19 931 725
- DE-U- 29 600 522
- US-A- 3 337 801
- US-A- 6 100 679

## Beschreibung

Es sind Handwerkzeuge, wie z.B. Schraubendreher, Zangen, Messer, bekannt welche mit einer Einrichtung zur Spannungs-, bzw. Stromdetektion ausgestattet sind und für den Einsatz an Elektroinstallationen, Elektrogeräten und allgemein an Wechselstrom führenden Teilen bestimmt sind.

Aus der DE 3048443 ist ein Mehrzweckmesser und aus der DE 19513280 ist eine Zange bekannt welche bei metallischer Berührung der Zange, bzw. des Messers, mit einem Spannung führenden Teil und gleichzeitiger Berührung einer Elektrode, seitens des Benützers, welche am isolierenden Werkzeuggriff vorgesehen ist, durch Aufleuchten einer Lichtquelle dem Benützer anzeigt, dass das berührte Teil unter Spannung steht.

Die Einrichtungen ("Fasenprüfer") welche an derartigen bekannten Werkzeugen zwecks Spannungs- oder Stromdetektion vorgesehen sind, können eine Spannung nur anzeigen wenn ein elektrischer Kontakt des Werkzeuges einerseits mit dem Spannung führenden Teil und anderseits, über die im Griff vorgesehene Elektrode, mit dem Körper des Benützers hergestellt ist.

Aus der DE 19931725 ist ein Multifunktionswerkzeug bekannt welches eine Einrichtung für Mess- und/oder Prüffunktionen enthält welche es dem Benützer ermöglicht beispielsweise Spannung führende Leitungen innerhalb einer Mauer oder einer Decke zu überprüfen, bzw. aufzuspüren.

Aus der DE 3439504 ist ein einpoliges Prüfgerät bekannt welches zur Überprüfung eines isolierten Leiters auf eine etwaige Unterbrechung und zur Lokalisierung der Unterbrechungsstelle geeignet ist.

Aus der US 6,100,679 ist ein Werkzeug bekannt welches bei metallischem Kontakt mit einem Spannung führenden Teil, die Spannung anzeigt, ohne dass ein leitender Kontakt zwischen Werkzeug und Benutzer nötig ist.

Diese Geräte werden meistens als Schraubendreher ausgeführt und ermöglichen durch Einbau eines Induktionssensors, wie in der US 3,337,801 beschrieben, auch eine berührungslose Prüfung Spannung führender Leitungen indem deren kapazitives elektrisches Wechselfeld welches sich um das Wechselstrom führende Kabel erstreckt, optisch und/oder akustisch angezeigt wird.
Bei der Ausführung dieser Geräte entsprechen die Schraubendreherklinge sowie der Griff des Werkzeuges selten den Anforderungen welche an ein qualitativ hochwertiges Werkzeug gestellt werden da erfahrungsgemäß der Schraubendreher primär als "Teststift" und nur gelegentlich auch als Schraubendreher eingesetzt wird. Aus diesem Grund sind die Griffe solcher Schraubendreher meist mit einem Klips ausgestattet welcher es ermöglicht das Gerät nach Art eines Schreibstiftes griffbereit am Rand einer Westentasche zu sichern.
Diese bekannten Geräte zeigen eine Spannung nur infolge Berührung, bzw. Entlangführung an einem isolierten Leiter, an; das mit derartigen Geräten ausgestattete Werkzeug wird also bewusst vom Benützer an das eventuell Spannung führende Teil herangeführt um das Vorhandensein oder Nichtvorhandensein einer Spannung festzustellen, bzw. um die Unterbrechung eines Leiters aufzuspüren und zu lokalisieren.
Es sind weiters Spannungsprüfer bekannt welche meist über eine Sonde welche nahe einer Schraubendreherklinge vorgesehen ist, eine berührungslose, optische und/oder akustische Erkennung von Wechselspannungen ermöglichen; auch derartige berührungslose Spannungsprüfer sind in der Praxis gut als Prüfgerät aber nur beschränkt als Schraubendreher verwendbar. Der elektronische Teil solcher Prüfgerät besteht wesentlich aus einer Gleichspannungsquelle, einer Leuchtdiodenanzeige (LED) und/oder einem Tongenerator und einem Stromkreis mit Sonde welche bei Beeinflussung durch ein kapazitves elektrisches Wechselfeld, wie es sich um Wechselspannung führende Teile erstreckt, anspricht.
Die Praxis hat gezeigt, dass derartige bekannte Spannungsprüfer mit oder ohne Werkzeugfunktion selten verwendet werden um, vor Arbeitsbeginn, systematisch und gewissenhaft zu überprüfen ob die zu bearbeitenden Teile elektrischer Installationen oder elektrischer Geräte auch wirklich spannungsfrei sind.
Trotz Einhaltung der geltenden Sicherheitsvorschriften welche für die Durchführung von Arbeiten an Elektroinstallationen und/oder an elektrischen Geräten vorgesehen sind, kann es vorkommen, dass während der Durchführung der Arbeiten die Installation, bzw. die Geräte, unbeabsichtigt und ohne Warnung, unter Spannung gesetzt werden. In solchen Fällen kann es sein dass die, die Arbeit ausführende Person mit einem Spannung führenden Teil Körperkontakt hat, was je nach den Umständen welchen die Person ausgesetzt ist, zu einem mehr oder weniger schweren Unfall führen kann. Es kann aber auch sein, dass die Person mit einem elektrisch isolierten Werkzeug (Schraubendreher, Schere, Zange, Seitenschneider, Messer, usw.) gerade an einem Spannung führende Teil oder Leiter arbeitet ohne mit diesem elektrischen Kontakt zu haben, in diesem Fall merkt der Benützer des Werkzeuges nicht, dass nun Spannung vorhanden ist. Erst wenn die Person (unter bestimmten Umständen) mit ihrem Körper mit den Spannung führenden Teilen in elektrischen Kontakt kommt oder wenn über das Werkzeug, z.B. beim Durchschneiden zweier Leiter ein Kurzschluss entsteht, wird diese merken dass die Teile nun unter Spannung stehen, zu diesem Zeitpunkt ist jedoch meist der Unfall bereits passiert.

Der Erfindung liegt die Aufgabe zugrunde handwerklich effiziente Handwerkzeuge wie Scheren, Messer oder Zangen für die Ausführung von Arbeiten an Elektroinstallationen und/oder Elektrogeräten mit einem berührungslosen leicht austauschbaren Spannungsprüfer so auszustatten dass durch diesen, bereits beim Nähern des Werkzeuges an ein Spannung führendes Teil, bzw. beim unter Spannung Setzen der Teile an welchen gearbeitet wird, ein deutliches optisches und/oder akustisches Warnsignal gegeben wird.
Das mit dem berührungslosen Spannungsprüfer auszustattende Werkzeug, beziehungsweise dessen Griff, ist so gestaltet, dass unterschiedliche Werkzeuge mit dem selben Sannungsprüfer ausgerüstet werden können, bzw. dass ein defekter Spannungsmesser auf einfache Weise durch einen funktionstüchtigen ausgetauscht werden kann.

Der Benützer der erfindungsgemäß mit berührungslosem Spannungsprüfer ausgestatteten Werkzeuge soll also bei unbeabsichtigter Spannungszufuhr, während der Ausführung der Arbeiten an den entsprechenden Leitern oder Geräten, bzw. beim Nähern eines erfindungsgemäßen Werkzeuges an einen Spannung führenden Leiter oder an ein Gerät, durch den Spannungsprüfer optisch und/oder akustisch gewarnt werden.

Diese Aufgabe wird erfindungsgemäß dadurch gelöst, dass der Werkzeuggriff in einer entsprechenden Ausformung den berührungslosen Spannungsprüfer leicht auswechselbar aufnimmt und zwar so, dass während der Handhabung des Werkzeuges der optische Signalgeber gut sichtbar und/oder der akustische Signalgeber gut hörbar ist. Die austauschbare Spannungsquelle welche den Stromkreis des Spannungsprüfers und den Signalgeber speist wird in einem Bereich des am Werkzeug anbringbaren Spannungsmessers vorgesehen wo diese leicht ausgetauscht werden kann.

Als Sonde für den Spannungsprüfer ist es bekannt einen offenen Transistor mit Kontaktfahne zu verwenden; die Erfindung schließt nicht aus, den metallischen Teil des Werkzeuges als Elektrode, bzw. als Verlängerung der Kontaktfahne des Transistors zu nutzen. Vorteilhafterweise wird der Sensor des Spannungsprüfers so positioniert, dass dieser sich aus dem Gehäuse in Richtung Werkzeugspitze erstreckt, um beim Nähern des Werkzeuges an ein Spannung führendes Teil, bereits bevor das Werkzeug das zu bearbeitende Teil berührt, das kapazitive elektrische Wechselfeld wahrnehmen und das Warnsignal auslösen zu können.

Die auswechselbar, an verschiedenartigen Werkzeugen gehalterten , Spannungsprüfer setzen voraus, dass die Griffe der verschiedenen Werkzeuge so ausgestaltet sind, dass der selbe Spannungsprüfer an jedem der Griffe anbaubar, einsteckbar oder anklipsbar ist oder dass das Gehäuse des Spannungsprüfers so ausgestaltet ist, dass ein Aufbau oder Anklipsen an jedem der Griffe der verschiedenen Werkzeuge möglich ist; dabei wird auch eine Magnethalterung nicht ausgeschlossen. Bei den auswechselbaren Spannungsprüfern kann vorgesehen werden, dass die Sonde, bzw. die Elektrode, des Spannungsprüfers in der Länge variiert oder dass diese in jedem der verschiedenen Werkzeuge bereits, z.B. in der isolierenden Ummantelung oder im Griff, vorgesehen ist und dass der Spannungsprüfer eine Kontaktstelle für den Anschluss an diese Sonde oder Elektrode aufweist. Wird als Elektrode der Metallteil des Werkzeuges genutzt so wird über die besagte Kontaktstelle die elektrische Verbindung vom Spannungsprüfer zum Metallteil hergestellt.

Es ist bekannt, dass die berührungslosen Spannungsprüfer nur bei Wechselspannung in einem Spannungsbereich von ca. 50 bis 600 V und einem Frequenzbereich von ca. 50 bis 500 Hz ansprechen; diese Bereiche entsprechen jedoch den weitaus häufigsten Anwendungsbereichen an gewerblichen und zivilen elektrischen Installationen und Geräten. Die berührungslosen Spannungsprüfer funktionieren nicht wenn die stromführenden Leiter oder Teile mit einer elektrischen Abschirmung versehen sind, in diesem Fall ist auch die Warnfunktion der erfindungsgemäß ausgestatteten Werkzeuge nicht gegeben.

Die Erfindung wird nachstehend anhand einiger, in den beigelegten Zeichnungen schematisch dargestellter, erfindungsgemäßer, mit berührungslosen Spannungsprüfern ausgestatteten, Elektrikerscheren näher erklärt, wobei die Erfindung aber auch die Ausstattung anderer kleiner Elektrikerwerkzeuge mit berührungslosen Spannungsmessern als Warneinrichtung umfassen soll.
Fig. 1 zeigt in perspektivischer Darstellung eine erfindungsgemäße Elektrikerschere mit einem berührungslosen Spannungsprüfer welcher ein eigenes Gehäuse aufweist und an einem der Scherengriffe, zwischen daran angeformte Backen angeklipst ist.
Fig. 1a zeigt das Detail der in Fig. 1 dargestellten Klipsverbindung, als Querschnitt durch den Scherengriff und den Spannungsmesser im Bereich der elastischen Backen.
Fig. 2 zeigt in perspektivischer Darstellung eine erfindungsgemäße Elektrikerschere mit einem berührungslosen Spannungsprüfer welcher ein eigenes Gehäuse aufweist und an einem der Scherengriffe in eine daran angeformte Hülse eingeschoben ist.
Fig. 2a zeigt das Detail der in Fig. 2 dargestelltenten Halterung als Querschnitt durch den Scherengriff und den Spannungsmesser im Bereich der am Griff angeformten Hülse.
Fig. 3 zeigt in perspektivischer Darstellung eine erfindungsgemäße Elektrikerschere mit einem berührungslosen Spannungsprüfer welcher ein Gehäuse aufweist von welchem zwei elastische Backen abstehen mittels welcher der Spannungsprüfer an einem der Scherengriffe angeklipst ist.
Fig. 3a zeigt das Detail der in Fig. 3 dargestellten Klipsverbindung, als Querschnitt durch den Scherengriff und den Spannungsprüfer im Bereich der elastischen Backen.
Fig. 4 zeigt in perspektivischer Darstellung eine erfindungsgemäße Elektrikerschere mit einem berührungslosen Spannungsprüfer welcher ein Gehäuse aufweist an das, im Auflagebereich an den Scherengriff, ein Sockel mit zwei Ösen für die Befestigung mittels Kabelbinder angeformt ist.
Fig. 4a zeigt das Detail der in Fig. 4 dargestellten Verbindung mittels Kabelbinder, als Querschnitt durch den Scherengriff und den Spannungsprüfer im Bereich eines Kabelbinders.

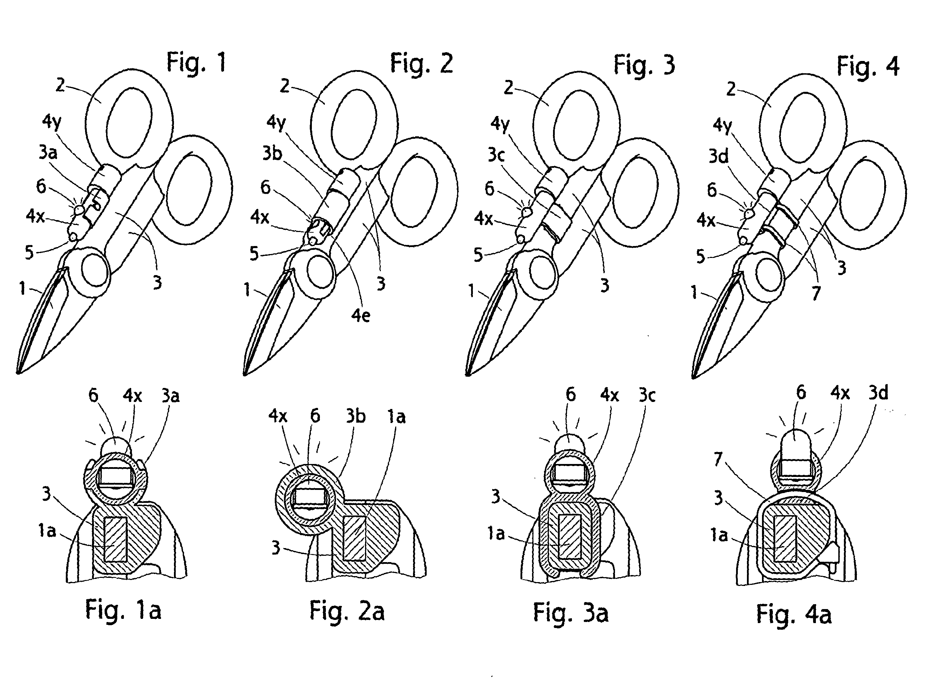

Die Elektrikerschere (Fig. 1 bis Fig.4) besteht aus den Metallklingen 1 welche durch einen Zapfen verbunden sind und hinter diesem als Armstumpfe 1a sich weitererstrecken; an diesen sind zwei ringförmige Griffe 2 aus elektrisch isoliertem Werkstoff angeformt, wobei diese Griffe 2 mit den Abdeckungen 3 welche die Armstumpfe 1a und den Zapfenbereich isolierend umhüllen, einstückig sind.

Die in den Fig. 1 bis 4a dargestellten Ausführungsbeispiele zeigen Elektrikerscheren welche mit auswechselbaren Spannungsprüfer 4x ausgestattet sind. Der berührungslose Spannungsprüfer 4x über ein eigenes Gehäuse aus welchem im, zur Werkzeugspitze ausgerichteten, Bereich die Sonde 5 vorgesehen ist während die Lichtquelle (LED) 6 an einer, während der Handhabung der Schere, vom Benutzer nicht abgedeckten Stelle vorgesehen ist. Vorteilhafterweise ist in einem anschließenden Gehäuseteil 4y die Stromquelle für den Spannungsprüfer untergebracht, dieser Gehäuseteil ist, zwecks Auswechseln der Stromquelle, mit einem entsprechenden Deckel versehen. Erfindungsgemäß kann die Schere mit federnden Klipsbacken 3a (Fig. 1, 1a) für das Anklipsen des Spannungsprüfers mit Gehäuse 4x, oder mit einer Hülse 3b (Fig. 2, 2a), bzw. mit Ringen, zum Einschieben des Spannungsprüfers, ausgestattet sein. Im letzteren Fall (Fig. 2, 2a) ist die Lichtquelle 6 nicht vorstehend angeordnet und am Gehäuse 4x kann ein federnder Sperrzahn 4e vorgesehen sein.

Die Halterungselemente für die Befestigung des Spannungsprüfers an der Schere können auch am Gehäuse 4x des Spannungsprüfers vorgesehen sein. Die am Gehäuse 4x des Spannungsprüfers angeformten elastischen Klipsbacken 3c (Fig. 3, 3a) halten den Spannungsprüfer am Scherenarm fest. Eine weitere Befestigungsart (Fig. 4, 4a) wird durch einen am Gehäuse 4x angeformten Sockel 3d mit Ösen zwecks Durchführen von Kabelbindern 7 realisiert.

Die Erfindung schließt nicht aus, dass bei den auswechselbar am Handwerkzeug befestigten Spannungsprüfern die Sonde 5 in der Werkzeugummantelung untergebracht ist und über einen Leiter und einem entsprechenden Kontaktelement mit der Elektronik des Spannungsprüfers in Verbindung steht, ebenso kann auch bei Kontaktelement die Verbindung zum Metallteil des Handwerkzeuges herstellen.

Die auswechselbar am Handwerkzeug befestigten Spannungsprüfer ermöglichen es verschiedene und eventuell unterschiedliche Handwerkzeuge mit einem Spannungsprüfer als Warneinrichtung auszustatten, dabei können diese für den Anbau im entsprechenden Bereich passend ausgeformt sein. Die Befestigung z.B. mittels Kabelbinder 7 (Fig. 4, 4a) ermöglicht es aber auch den Spannungsprüfer an den meisten handelsüblichen Handwerkzeugen zu befestigen. Sobald der Benützer des mit berührungslosem Spannungsprüfer ausgerüsteten Handwerkzeuges, dieses in die Nähe eines Wechselspannung führenden Leiters oder Teiles bewegt, wird über die Sonde 5 oder über eine entsprechende Elektrode, bzw. über das als Elektrode genutzte Metallteil des Handwerkzeuges, das, sich um den Spannung führenden Leiter oder Teil erstreckende, kapazitive Wechselfeld wahrgenommen und durch Aufleuchten der Lichtquelle 6 und/oder durch einen Tongenerator warnend angezeigt.

## Patentansprüche

1. Berührungsloser Spannungsprüfer mit Anzeige-Lichtquelle (6), Sonde oder Elektrode (5) und Stromquelle, welcher als Warneinrichtung an Handwerkzeugen wie Scheren, Messern oder Zangen mit elektrisch isolierten Griffen (3) vorgesehen ist, **dadurch gekennzeichnet, dass** der Spannungsmesser (4x) über ein eigenes Gehäuse verfügt welches, zwecks leichter Austauschbarkeit in, am Werkzeuggriff befestigte oder angeformte Klipsbacken (3a), Hülsen (3b) oder Ringe eingeschoben oder eingeklipst werden kann oder welches selbst mit Klipsbacken (3c) versehen ist um am Werkzeug aufgeklipst zu werden, wobei die Sonde oder Elektrode (5) zur Werkzeugspitze hin ausgerichtet ist und die Anzeige-Lichtquelle gut sichtbar bleibt.

2. Berührungsloser Spannungsprüfer gemäß Anspruch 1, **dadurch gekennzeichnet, dass** die Befestigung am Werkzeuggriff über Kabelbinder (7) erfolgt welche den Spannungsprüfer oder einen an diesen angeformten Auflagesockel (3d) und den entsprechenden Werkzeuggriff umgreifen.

3. Berührungsloser Spannungsprüfer gemäß Anspruch 1, **dadurch gekennzeichnet, dass** das Gehäuse des Spannungsprüfers (4x) mit einem Magnet ausgestattet ist welcher an einem, in der Isolierschicht des Werkzeuges eingelassenen Eisenelement und/oder an einem nicht abisolierten Stahlteil des Werkzeuges eine Haftverbindung herstellt.

4. Berührungsloser Spannungsmesser gemäß Anspruch 1, **dadurch gekennzeichnet, dass** der Spannungsprüfer (4x) anstatt der Sonde oder Elektrode (5) eine elektrisch leitende Kontaktstelle aufweist welche in, am Werkzeug befestigter Position des Spannungsprüfers (4x), mit dem metallischen Teil des Werkzeuges oder mit einer am Werkzeug vorgesehenen Elektrode oder Sonde (5) in leitender Verbindung steht.

## Claims

1. Contactless voltage tester having a display light source (6), probe or electrode (5) and power source, which is provided as a warning device on handtools such as shears, knives or pliers with electrically insulated handles (3), **characterized in that** the voltmeter (4x) has its own housing which, with ease of replaceability, can be pushed or clipped into clip jaws (3a) sleeves (3b) or rings which are attached to or integrally formed on the tool handle, which is itself provided with clip jaws (3c) in order to be clipped on the tool, wherein the probe or electrode (5) is aligned towards the tool tip, and the display light source can still be seen well.

2. Contactless voltage tester according to Claim 1, **characterized in that** the attachment to the tool handle is provided via cable ties (7) which clasp the voltage tester or a contact cap (3d), which is integrally formed thereon, and the corresponding tool handle.

3. Contactless voltage tester according to Claim 1, **characterized in that** the housing of the voltage tester (4x) is equipped with a magnet which produces an adhesive connection to an iron element incorporated in the insulating layer of the tool and/or to an unstripped steel part of the tool.

4. Contactless voltmeter according to Claim 1, **characterized in that** the voltage tester (4x) has an electrically conductive contact point instead of the probe or electrode (5), which contact point is conductively connected to the metallic part of the tool or to an electrode or probe (5) provided on the tool when the voltage tester (4x) is in the position attached to the tool.

## Revendications

1. Détecteur de tension sans contact, muni d'une source lumineuse d'affichage (6), sonde ou électrode (5) et source de courant, prévu en tant que dispositif avertisseur sur des outils à main, tels que des ciseaux, couteaux ou pinces avec des poignées (3) isolées de l'électricité, **caractérisé en ce que** le détecteur de tension (4x) dispose d'un boîtier propre qui, dans un but de plus facile interchangeabilité, peut être inséré ou enclipsé dans des mâchoires de clipsage (3a), douille (3b) ou bagues, fixées ou formées d'un seul tenant sur la poignée de l'outil, ou boîtier muni lui-même de mâchoires de clipsage (3c), de manière à pouvoir être clipsé sur l'outil, la sonde ou électrode (5) étant tournée vers la pointe de l'outil et la source lumineuse d'affichage restant bien visible.

2. Détecteur de tension sans contact selon la revendication 1, **caractérisé en ce que** la fixation sur la poignée de l'outil s'effectue par l'intermédiaire de serre-câbles (7), entourant le détecteur de tension ou un socle de pose (3d), formé d'un seul tenant sur celui-ci, et la poignée de l'outil correspondante.

3. Détecteur de tension sans contact selon la revendication 1, **caractérisé en ce que** le boîtier du détecteur de tension (4x) est équipé d'un aimant établissant une liaison d'adhésion sur un élément en fer inséré dans la couche isolante de l'outil et/ou sur une partie en acier, non dénudée, de l'outil.

4. Détecteur de tension sans contact selon la revendication 1, **caractérisé en ce que**, au lieu de la sonde ou électrode (5), le détecteur de tension (4x) présente un emplacement de contact conducteur de l'électricité, qui, lorsque le détecteur de tension (4x) se trouve dans la position fixé sur l'outil, est en relation conductrice avec la partie métallique de l'outil ou avec une électrode ou sonde (5) prévue sur l'outil.
